(19) **Europäisches Patentamt** / **European Patent Office** / **Office européen des brevets**

(11) **EP 4 206 635 B1**

(12) **EUROPEAN PATENT SPECIFICATION**

(45) Date of publication and mention
of the grant of the patent:
**06.05.2026 Bulletin 2026/19**

(21) Application number: **21942395.1**

(22) Date of filing: **28.05.2021**

(51) International Patent Classification (IPC):
**G01L 1/16** *(2006.01)*   **H10N 30/30** *(2023.01)*
**H10N 30/01** *(2023.01)*

(52) Cooperative Patent Classification (CPC):
**H10N 30/302; G01L 1/16; H10N 30/01**

(86) International application number:
**PCT/CN2021/096891**

(87) International publication number:
**WO 2022/246821 (01.12.2022 Gazette 2022/48)**

(54) **PIEZOELECTRIC SENSOR AND HAPTIC FEEDBACK DEVICE**

PIEZOELEKTRISCHER SENSOR UND VORRICHTUNG MIT HAPTISCHER RÜCKMELDUNG

CAPTEUR PIÉZOÉLECTRIQUE ET DISPOSITIF DE RÉTROACTION HAPTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**05.07.2023 Bulletin 2023/27**

(73) Proprietors:
- **BOE Technology Group Co., Ltd.**
  **Beijing 100015 (CN)**
- **Beijing BOE Technology Development Co., Ltd.**
  **Beijing 100176 (CN)**

(72) Inventor: **CHEN, Yuju**
**Beijing 100176 (CN)**

(74) Representative: **Cohausz & Florack**
**Patent- & Rechtsanwälte**
**Partnerschaftsgesellschaft mbB**
**Bleichstraße 14**
**40211 Düsseldorf (DE)**

(56) References cited:
**WO-A1-2020/261963   CN-A- 105 765 750**
**CN-A- 108 267 263   CN-A- 111 916 555**
**CN-A- 112 129 432   CN-U- 205 919 915**
**JP-A- 2006 339 834   JP-A- 2006 339 834**
**JP-A- 2019 216 165   US-A1- 2016 204 333**
**US-B1- 6 297 579**

# Description

## Field

The present disclosure relates to the field of sensor technology, in particular to a piezoelectric sensor and a haptic feedback device.

## Background

Haptic feedback (known as Haptics) is the focus of today's technology development, and in particular, haptic feedback enables the terminal to interact with the human body through touch. Haptic feedback, in turn, can be divided into two categories, one is vibration feedback and the other is tactile reproduction technology. An example of prior art may be found in patent document US2016/204333 A1.

## Summary

The present disclosure provides a piezoelectric sensor, a fabrication method therefor, and a haptic feedback device. And, the solution is as follows.

An embodiment of the present disclosure provides a piezoelectric sensor, including: a base substrate, a first electrode layer, arranged on the base substrate; a piezoelectric thin film layer, arranged on a side of the first electrode layer facing away from the base substrate; an insulating layer, arranged on a side of the piezoelectric thin film layer facing away from the base substrate; and a second electrode layer, arranged on a side of the insulating layer facing away from the base substrate; where the insulating layer is in contact with at least part of the piezoelectric thin film layer; a capacitance of the piezoelectric thin film layer and a capacitance of the insulating layer satisfy a following relationship: $C_{PI} \geq 100 C_{PZT}$; where $C_{PI}$ represents the capacitance of the insulating layer and $C_{PZT}$ represents the capacitance of the piezoelectric thin film layer; where a side of the first electrode layer facing the piezoelectric thin film layer is provided with a plurality of first columnar structures; a side of the second electrode layer facing the piezoelectric thin film layer is provided with a plurality of second columnar structures.

In some embodiments, the piezoelectric thin film layer includes at least one hollow structure, and each of the at least one hollow structures is filled with the insulating layer.

In some embodiments, an orthographic projection of the piezoelectric thin film layer on the base substrate covers an orthographic projection of the insulating layer on the base substrate.

In some embodiments, an orthographic projection of the insulating layer on the base substrate and an orthographic projection of the piezoelectric thin film layer on the base substrate overlap each other.

In some embodiments, a material of the insulating layer includes at least one of polyimide, silica, or alumina.

In some embodiments, a thickness of the insulating layer and a thickness of the piezoelectric thin film layer satisfy a following relationship:

$$d_{PI} \leq 0.1 * d_{PZT};$$

where $d_{PI}$ represents the thickness of the insulating layer and $d_{PZT}$ represents the thickness of the piezoelectric thin film layer.

In some embodiments, a thickness of the insulating layer is greater than or equal to 50 nm; and the thickness of the insulating layer is less than or equal to 200 nm.

In some embodiments, a thickness of the piezoelectric thin film layer is greater than 0; and the thickness of the piezoelectric thin film layer is less than or equal to 2 $\mu$m.

In some embodiments, a resistance of the piezoelectric thin film layer and a resistance of the insulating layer satisfy a following relationship:

$$R_{PI} \geq 1000 R_{PZT};$$

where $R_{PI}$ represents the resistance of the piezoelectric thin film layer and $R_{PZT}$ represents the resistance of the insulating layer.

In some embodiments, a side of the piezoelectric thin film layer facing away from the base substrate is provided with a lyophilic material layer.

In some embodiments, a material of the piezoelectric thin film layer includes at least one of aluminum nitride, zinc oxide, lead zirconate titanate, barium titanate, lead titanate, potassium niobate, lithium niobate, lithium tantalate, or lanthanum gallium silicate.

In some embodiments, a side of the first electrode layer facing the piezoelectric thin film layer is provided with a plurality of third columnar structures, the side of the second electrode layer facing the piezoelectric thin film layer is provided with a plurality of fourth columnar structures, and an orthographic projection of each of the third columnar structures on the base substrate does not overlap with an orthographic projection of each of the fourth columnar structures on the base substrate.

Accordingly, an embodiment of the present disclosure provides a haptic feedback device, including a haptic feedback circuit and a piezoelectric sensor as described in any one of the above; where:

the haptic feedback circuit is arranged on a side of the second electrode layer facing away from the first electrode layer; or
the haptic feedback circuit is arranged on a side of the first electrode layer facing away from the second electrode layer;
where the haptic feedback circuit is configured to generate a voltage pulse in accordance with a received instruction to cause a structural body to vibrate.

## Brief Description of the Drawings

Fig. 1 is a schematic top view of a piezoelectric layer with cracks in a thin film vibration chip in the related art.
Fig. 2 is a schematic structural diagram of a piezoelectric sensor according to an embodiment of the present disclosure.
Fig. 3 is another schematic structural diagram of the piezoelectric sensor according to an embodiment of the present disclosure.
Fig. 4 is another schematic structural diagram of the piezoelectric sensor according to an embodiment of the present disclosure.
Fig. 5 is another schematic structural diagram of the piezoelectric sensor according to an embodiment of the present disclosure.
Fig. 6 is another schematic structural diagram of the piezoelectric sensor according to an embodiment of the present disclosure.
Fig. 7 is another schematic structural diagram of the piezoelectric sensor according to an embodiment of the present disclosure.
Fig. 8 is another schematic structural diagram of the piezoelectric sensor according to an embodiment of the present disclosure.
Fig. 9 is another schematic structural diagram of the piezoelectric sensor according to an embodiment of the present disclosure.
Fig. 10 is a schematic structural diagram of a haptic feedback device according to an embodiment of the present disclosure.
Fig. 11 is a method flow diagram of a fabrication method for the piezoelectric sensor according to an embodiment of the present disclosure.
Fig. 12 is a method flowchart of step S103 in Fig. 11.

## Detailed Description of the Embodiments

In order to make objectives, technical solutions and advantages of embodiments of the disclosure clearer, the technical solutions of embodiments of the disclosure are described clearly and completely below with reference to the drawings of embodiments of the disclosure. Apparently, the described embodiments are some, not all, of the embodiments of the disclosure. Embodiments in the disclosure and features in the embodiments may be mutually combined under the condition of no conflict. Based on the described embodiments of the disclosure, all other embodiments obtained by those ordinarily skilled in the art without creative work fall within the protection scope of the disclosure.

Unless otherwise defined, technical or scientific terms used in the present disclosure shall have the ordinary meaning as understood by those of ordinary skill in the art to which this present disclosure belongs. The words "including," "comprising," and the like are used in this disclosure to mean that elements or items preceding the word appear to encompass elements or items listed after the word and equivalents thereof, without excluding other elements or items.

The thin film piezoelectric material has the characteristics of high dielectric constant and transparency, and is well-suited for screen-integrated vibrator structures, when the surface charge distribution is uneven to lead accumulation or the voltage is too high, the vibrator undergoes breakdown phenomena, for example, the upper and lower electrodes remain open, but the piezoelectric thin film layer structure is damaged, and for another example, the upper and lower electrodes are short-circuited due to breakdown, resulting in failure of the entire vibrator. The main cause of short circuit is the stress of particles, granules or films in the process, which leads to cracks in the piezoelectric film layer. In this crack state, if the electrode is directly deposited on the piezoelectric film layer, it will lead to high short circuit risk. Therefore, how to avoid short circuit of the piezoelectric sensor has become an urgent technical problem to be solved.

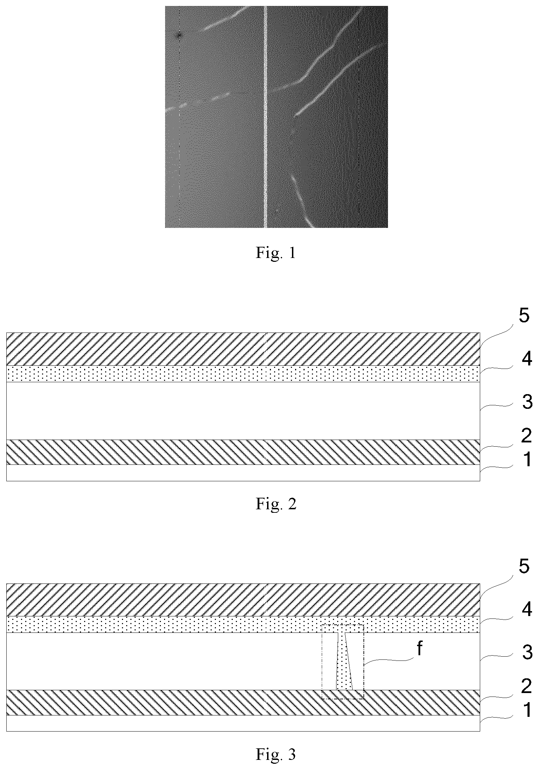

In the related art, Fig. 1 is a schematic top view of a piezoelectric layer with cracks in a thin film vibration chip in the related art, during the process, the stress of particles, granules or films leads to cracks in the piezoelectric layer, and if the electrode is deposited directly on the piezoelectric layer, the cracks will lead to short circuit of the thin film vibration chip, thus reducing product yield.

In view of this, embodiments of the present disclosure provide a piezoelectric sensor, a fabrication method therefor, and a haptic feedback device for avoiding short circuits in the piezoelectric sensor and improving product yield.

Fig. 2 is a schematic structural diagram of a piezoelectric sensor according to an embodiment of the present disclosure, and the piezoelectric sensor, including: a base substrate 1, and a first electrode layer 2, a piezoelectric thin film layer 3, an insulating layer 4 and a second electrode layer 5 which are arranged in sequence away from the base substrate 1, where the insulating layer 4 is in contact with at least part of the piezoelectric thin film layer 3.

In some embodiments, the base substrate 1 can be a substrate made of glass, or silicon or silicon dioxide ($SiO_2$), or sapphire, or metal wafer, which is not limited here, and the skilled person can set up the base substrate 1 according to the needs of the actual application.

In some embodiments, the first electrode layer 2 may be made of indium tin oxide (ITO), the first electrode layer 2 can also be made of indium zinc oxide (IZO), or one of titanium gold (Ti-Au) alloy, titanium aluminum titanium (Ti-Al-Ti) alloy, titanium molybdenum (TiMo) alloy, and in addition, the first electrode layer 2 may be made of one of titanium (Ti), gold (Au), silver (Ag), molybdenum (Mo), copper (Cu), tungsten (W), and chromium (Cr), and the skilled person can arrange the first electrode layer 2 according to the needs of the actual application, which is not limited here. Accordingly, the second electrode layer 5 may also be made of the same material as the first electrode layer 2, which is not described in detail here.

In some embodiments, a material of the piezoelectric thin film layer 3 may include at least one of aluminum nitride (AIN), ZnO (zinc oxide), lead zirconate titanate (Pb (Zr, Ti)$O_3$, PZT), barium titanate (BaTiO$_3$), lead titanate (PbTiO$_3$), potassium niobate (KNbO$_3$), lithium niobate (LiNbO$_3$), lithium tantalate (LiTaO$_3$), or gallium lanthanum silicate (La$_3$Ga$_5$SiO$_{14}$), in this way, the vibration characteristics of the piezoelectric sensor are guaranteed while at the same time the piezoelectric sensor is transparent, in particular the material from which the piezoelectric thin film layer 3 is made can be selected according to the actual usage needs of the person skilled in the art, which is not limited here. When the piezoelectric thin film layer 3 is made using PZT, the piezoelectric properties of the respective piezoelectric sensor are guaranteed since the PZT has a high electric coefficient, the respective piezoelectric sensor can be applied in a haptic feedback device, and the PZT has high light transmittance that does not affect the display quality of the display device when it is integrated into the display device.

The insulating layer 4 between the piezoelectric thin film layer 3 and the second electrode layer 5 is in contact with at least part of the piezoelectric thin film layer 3, the insulating layer 4 may be in contact with all of the piezoelectric thin film layer 3, for example, the insulating layer 4 completely covers the side of the piezoelectric thin film layer 3 facing away from the base substrate 1, Fig. 2 illustrates that the insulating layer 4 completely covers the side of the piezoelectric thin film layer 3 facing away from the base substrate 1, and may also be in contact with a part of the piezoelectric thin film layer 3, for example, the insulating layer 4 fills only cracks in the piezoelectric thin film layer 3, for another example, the insulating layer 4 is disposed only within a portion of the area of the piezoelectric thin film layer 3 facing away from the base substrate 1.

In some embodiments, the piezoelectric thin film layer 3 may be arranged entirely on a side of the first electrode layer 2 facing away from the base substrate 1, the efficiency of fabrication of the piezoelectric sensor is improved, and in addition, the piezoelectric thin film layer 3 can be patterned as needed, for example, the piezoelectric thin film layer 3 is arranged in areas on the side of the first electrode layer 2 facing away from the base substrate 1, thereby enabling flexible design of the piezoelectric sensor. In some embodiments, since the insulating layer 4 is in contact with at least part of the piezoelectric thin film layer 3, even in the presence of cracks in the piezoelectric thin film layer 3, by means of the insulating layer 4 it is possible to effectively fill the cracks. Thus, after the second electrode layer 5 is deposited, the existence of the insulating layer 4 prevents the short circuit between the second electrode layer 5 and the first electrode layer 2 due to contact, thereby avoiding the short circuit risk of the piezoelectric sensor and improving the product yield.

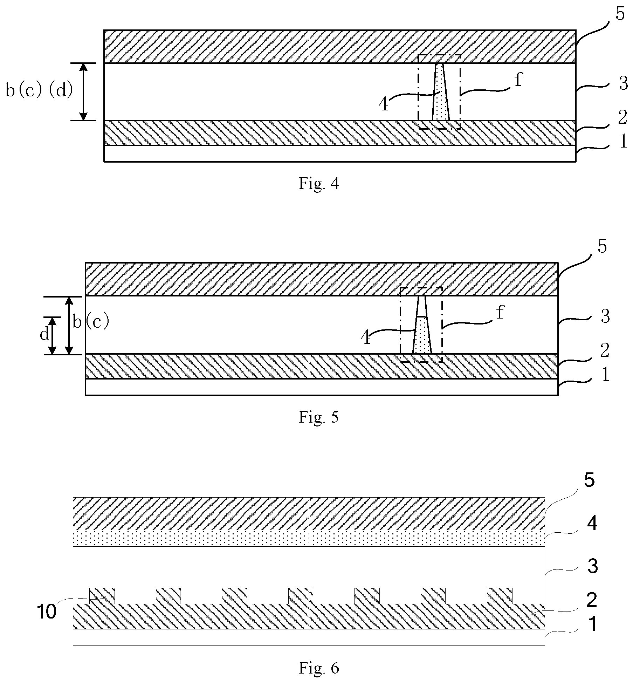

In an embodiment of the present disclosure, Fig. 3 is a schematic structural diagram of the piezoelectric sensor, the piezoelectric thin film layer 3 includes at least one hollow structure f on the side facing away from the base substrate 1, each of the hollow structures f being filled with the insulating layer 4. There may be one or a plurality of hollow structures f, and the case of one hollow structure f is illustrated in Fig. 3, and of course there may be a plurality of hollow structures f, which is not limited herein. The hollow structure f may be a crack present in the piezoelectric thin film layer 3. When there are a plurality of the hollow structures f, the sizes of the hollow structures f may be unequal, the distribution of which may be randomly distributed according to actual process conditions. As shown in Fig. 4, the insulating layer 4 completely fills each of the hollow structures f, and the thickness of the insulating layer 4 filled in each of the hollow structures f is equal to the depth of the respective hollow structure f, both the thickness direction of the insulating layer 4 and the depth direction of the hollow structure f are in a direction perpendicular to the plane of the base substrate 1, the term "equal" is not exactly equal, may be approximately equal, or roughly equal. As such, each of the hollow structures f in the piezoelectric thin film layer 3 is effectively filled by the insulating layer 4, thus avoiding the risk of short circuits of the piezoelectric sensor, moreover, since the insulating layer 4 completely fills each of the hollow structures f, when other parts of the insulating layer 4 completely cover the side of the piezoelectric thin film layer 3 facing away from the base substrate 1 except for the part filled to each of the hollow structures f, the flush arrangement of the side of the piezoelectric thin film layer 3 away from the base substrate 1 is realized, thus ensuring the structural stability of the piezoelectric sensor made later and improving the service performance of the piezoelectric sensor.

In an embodiment of the present disclosure, in connection with Figs. 4 and 5, the orthographic projection of the insulating layer 4 on the base substrate 1 falls entirely within the area of the orthographic projection of the piezoelectric thin film layer 3 on the base substrate 1. In some embodiments, the insulating layer 4 may be provided only in an area where the piezoelectric thin film layer 3 is prone to cracking, for example, provided only in the area where the hollow structure f is present, the insulating layer 4 may be filled only in the hollow structure f, it may also be partially filled in the hollow structure f, for example, the overall thickness of the piezoelectric thin film layer 3 in a direction perpendicular to the plane of the base substrate 1 is b, the depth of the hollow structure f is c and the thickness of the insulating layer 4 in a direction perpendicular to the plane in which the base substrate 1 lies is d, $c \leq b$, $d \leq c$, wherein b = c = d when the insulating layer 4 completely fills the hollow structure f, as shown in Fig. 5, and b = c, d < c when the insulating layer 4 partially fills the hollow structure f, as shown in Fig. 6. As such, the hollow structure f on the piezoelectric thin film layer 3 is filled by the insulating layer 4, avoiding the risk of short circuits of the piezoelectric sensor.

In an embodiment of the present disclosure, still with reference to Fig. 3, the orthographic projection of the insulating layer 4 on the base substrate 1 and the orthographic projection of the piezoelectric thin film layer 3 on the base substrate 1 overlap with each other. In some embodiments, the insulating layer 4 may completely cover the side of the piezoelectric thin film layer 3 facing away from the base substrate 1, and even when the piezoelectric thin film layer 3 originally has cracks, the hollow structure f is effectively filled through the insulating layer 4, thus avoiding the short circuit risk of the piezoelectric sensor and improving the product yield.

In an embodiment of the present disclosure, the insulating layer 4 includes at least one of polyimide (PI), silica ($SiO_2$), alumina ($Al_2O_3$). In some embodiments, if the hollow structure f is present in the piezoelectric thin film layer 3, the hollow structure f tends to have strong capillary force and porosity, when a wet process is employed, the insulating layer 4 may flow through gravitational leveling into the hollow structure f, for example, when PI is coated on the side of the piezoelectric thin film layer 3 facing away from the base substrate 1 using a wet process, since PI has better leveling properties at the surface of the piezoelectric thin film layer 3, PI may quickly level the hollow structure f, while ensuring surface planarity on the side of the piezoelectric thin film layer 3 facing away from the base substrate 1 and avoiding the risk of short circuits of the piezoelectric sensor, since PI has the better high temperature curing (cyclization) property, after PI wet coating on the side of the piezoelectric thin film layer 3 facing away from the base substrate 1, high temperature curing of PI within the range of 200°C ~ 300°C forms the insulating layer 4, thereby ensuring stable insulating properties of the insulating layer 4 and improving the performance of the piezoelectric sensor.

In some embodiments, $SiO_2$ may also be coated on the side of the piezoelectric thin film layer 3 facing away from the base substrate 1 using a wet process, thereby leveling the hollow structure f, ensuring surface planarity on the side of the piezoelectric thin film layer 3 facing away from the base substrate 1, and avoiding the risk of short circuits of the piezoelectric sensor, after $SiO_2$ wet coating on the side of the piezoelectric thin film layer 3 facing away from the base substrate 1, the insulating layer 4 is formed by high temperature curing of $SiO_2$ at not less than 300°C, thereby ensuring stable insulating properties of the insulating layer 4 and improving the performance of the piezoelectric sensor.

In some embodiments, a dry deposition process may also be used to coat $Al_2O_3$ on the side of the piezoelectric thin film layer 3 facing away from the base substrate 1, avoiding the risk of short circuits of the piezoelectric sensor due to the insulation property of $Al_2O_3$ and further improving the performance of the piezoelectric sensor. Of course, the piezoelectric thin film layer 3 may be arranged in other ways and will not be described in detail herein.

In an embodiment of the present disclosure, the thickness of the insulating layer 4 and the thickness of the piezoelectric thin film layer 3 satisfy the following relationship:

$$d_{PI} \leq 0.1 * d_{PZT};$$

where $d_{PI}$ represents the thickness of the insulating layer 4 and $d_{PZT}$ represents the thickness of the piezoelectric thin film layer 3.

In some embodiments, the inventors found in practical studies that, at a certain thickness of the piezoelectric thin film layer 3, the thickness of the insulating layer 4 coated on a side of the piezoelectric thin film layer 3 facing away from the base substrate 1 is set to be less than 10% of the thickness of the piezoelectric thin film layer 3, for example, when the thickness of the piezoelectric thin film layer 3 is 2 $\mu$m, the insulating layer 4 may have a thickness of 200 nm, it can be 100 nm or 50 nm, and is not limited herein, the insulating properties of the insulating layer 4 can be guaranteed, so that the risk of short circuits of the piezoelectric sensor is avoided and the vibration properties of the piezoelectric sensor during high frequency AC driving are guaranteed, thus improving the performance of the piezoelectric sensor.

In an embodiment of the present disclosure, a thickness of the insulating layer 4 is greater than or equal to 50 nm; and the thickness of the insulating layer 4 is less than or equal to 200 nm.

In some embodiments, the insulating layer 4 has a thickness between 50 nm and 200 nm, such as 100 nm, 60 nm, or 50 nm, the insulating layer 4 has better insulating properties when the thickness of the insulating layer 4 is in the above range, thus effectively avoiding the risk of short circuits of the piezoelectric sensor.

In an embodiment of the present disclosure, a thickness of the piezoelectric thin film layer 3 is greater than 0; and the thickness of the piezoelectric thin film layer 3 is less than or equal to 2$\mu$m.

In some embodiments, the thickness of the piezoelectric thin film layer 3 is between 0 ~ 2 $\mu$m, for example, the thickness of the piezoelectric thin film layer 3 is 0.5 $\mu$m, for another example, the thickness of the piezoelectric thin film layer 3 is 1 $\mu$m, and for another example, the thickness of the piezoelectric thin film layer 3 is 2 $\mu$m, and in practical applications, the thickness of the piezoelectric thin film layer 3 may be set as close to zero as possible, thus taking into account a lightly thinned design of the piezoelectric sensor while ensuring better vibration properties of the piezoelectric thin film layer 3.

In an embodiment of the present disclosure, a capacitance of the piezoelectric thin film layer 3 and a capacitance of the insulating layer 4 satisfy the following relationship:

$$C_{PI} \geq 100C_{PZT};$$

where $C_{PI}$ represents the capacitance of the insulating layer 4 and $C_{PZT}$ represents the capacitance of the piezoelectric thin film layer 3.

In some embodiments, when the piezoelectric thin film layer 3 is of a certain material, for instance, a film layer made of $PbTiO_3$, and a thickness of the piezoelectric thin film layer 3 is fixed, an opposite area between the first electrode layer 2 and the second electrode layer 5 is fixed, from the capacitance calculation formula, the capacitance of the piezoelectric thin film layer 3 may be determined as:

$$C_{PZT} = \varepsilon_{PZT} \frac{A}{d_{PZT}}$$

, wherein $\varepsilon_{PZT}$ represents the dielectric constant of the piezoelectric thin film layer 3, which ranges from 450 ~ 1500, $d_{PZT}$ represents the thickness of the piezoelectric thin film layer 3, and A represents the opposite area between the first electrode layer 2 and the second electrode layer 5.

The capacitance of the piezoelectric thin film layer 3 and the capacitance of the insulating layer 4 satisfies the relationship: $C_{PI} \geq 100C_{PZT}$, the voltage loaded on the piezoelectric thin film layer 3 is:

$$V_{PZT} \approx \frac{1/j\omega C_{PZT}}{(1/j\omega C_{PI}) + (1/j\omega C_{PZT})} V_{AC} \approx V_{AC}$$

. In this way, when $C_{PI} \geq 100C_{PZT}$, substantial loss of voltage loaded on the piezoelectric thin film layer 3 by providing the insulating layer 4 on the surface of the piezoelectric thin film layer 3 facing away from the base substrate 1 is avoided, which guarantees better vibration properties of the piezoelectric sensor under high frequency AC drive and performance of the piezoelectric sensor. Furthermore, when the capacitance of the piezoelectric thin film layer 3 is certain, according to the capacitance relationship between the piezoelectric thin film layer 3 and the insulating layer 4 described above, the material as well as the thickness of the insulating layer 4 is selected, the dielectric constant of the insulating layer 4 ranges from 2.3 ~ 2.8 when the insulating layer 4 is made of PI material, the insulating layer 4 can be arranged according to the circumstances of the piezoelectric thin film layer 3 in practical applications, thereby enabling flexible preparation of the piezoelectric sensor.

In an embodiment of the present disclosure, the resistance of the piezoelectric thin film layer 3 and the resistance of the insulating layer 4 satisfy the following relationship:

$$R_{PI} \geq 1000R_{PZT};$$

where $R_{PI}$ represents the resistance of the piezoelectric thin film layer 3 and $R_{PZT}$ represents the resistance of the insulating layer 4.

In some embodiments, when the piezoelectric thin film layer 3 is of a certain material, for instance, a film layer made of $PbTiO_3$, and a thickness of the piezoelectric thin film layer 3 is fixed, a cross-sectional area of the piezoelectric thin film layer 3 parallel to a plane of the base substrate 1 is fixed, according to the resistance calculation formula, the capacitance of the piezoelectric thin film layer 3 can be determined as:

$$R_{PZT} = \rho_{PZT} \frac{d_{PZT}}{A}$$

, where $\rho_{PZT}$ represents the resistivity of the piezoelectric thin film layer 3, which is greater than or equal to $10^9$ Qcm, $d_{PZT}$ represents the thickness of the piezoelectric thin film layer 3, A represents the cross-sectional area of the piezoelectric thin film layer 3 parallel to the plane of the base substrate 1, which may be equal to the opposite area between the first electrode layer 2 and the second electrode layer 5.

When the resistance of the piezoelectric thin film layer 3 and the resistance of the insulating layer 4 satisfies $R_{PI} \geq 1000R_{PZT}$, the insulating layer 4 has better insulating properties, effectively avoiding the risk of short circuits of the piezoelectric sensor. When the resistance of the piezoelectric thin film layer 3 is certain, the material of the insulating layer 4 and the corresponding thickness range can be determined according to the resistance calculation formula, and the insulating layer 4 can be arranged according to the circumstances of the piezoelectric thin film layer 3 in practical applications, thereby enabling flexible preparation of the piezoelectric sensor.

In an embodiment of the present disclosure, the side of the piezoelectric thin film layer 3 facing away from the base substrate 1 is provided with a lyophilic material layer. The lyophilic material layer not only guarantee fast leveling of the insulating layer 4 on the side of the piezoelectric thin film layer 3 facing away from the base substrate 1, but also has better high temperature curing properties, thus ensuring stable insulating properties of the insulating layer 4, and further improving the performance of the piezoelectric sensor.

In an embodiment of the present disclosure, the following four implementation forms can be used to provide the first electrode layer 2 and the second electrode layer 5, the first implementation form is still shown in connection with Fig. 2, the first electrode layer 2 and the second electrode layer 5 are each a full plate-shaped structure, or at least one of the first electrode layer 2 and the second electrode layer 5 may also include a patterned design and the orthographic projection of the second electrode layer 5 on the substrate 1 falls entirely within the area of the orthographic projection of the first electrode layer 2 on the substrate 1.

In an embodiment of the present disclosure, a second implementation form is shown in Fig. 6, a plurality of first columnar structures 10 are arranged on a side of the first electrode layer 2 close to the piezoelectric thin film layer 3, the second electrode layer 5 is a full plate-shaped structure, or the second electrode layer 5 may also include a patterned design, as such, while avoiding short circuits of the piezoelectric sensor by the insulating layer 4, by the plurality of first columnar structures 10, the contact area between the piezoelectric thin film layer 3 and the first electrode layer 2 is increased, structural stability between the piezoelectric thin film layer 3 and the first electrode layer 2 is ensured and the performance of the piezoelectric sensor is improved.

In some embodiments, the sizes of the plurality of the first columnar structures 10 are same, and the first columnar structures 10 may be unequally spaced from each other, or equally spaced, and the distribution of the first columnar structures 10 may be arranged according to the needs of the actual application without limitation. When the first columnar structures 10 are equally spaced, uniformity of the transmission rate at each location of the piezoelectric sensor is guaranteed, which guarantees the performance of the piezoelectric sensor in use.

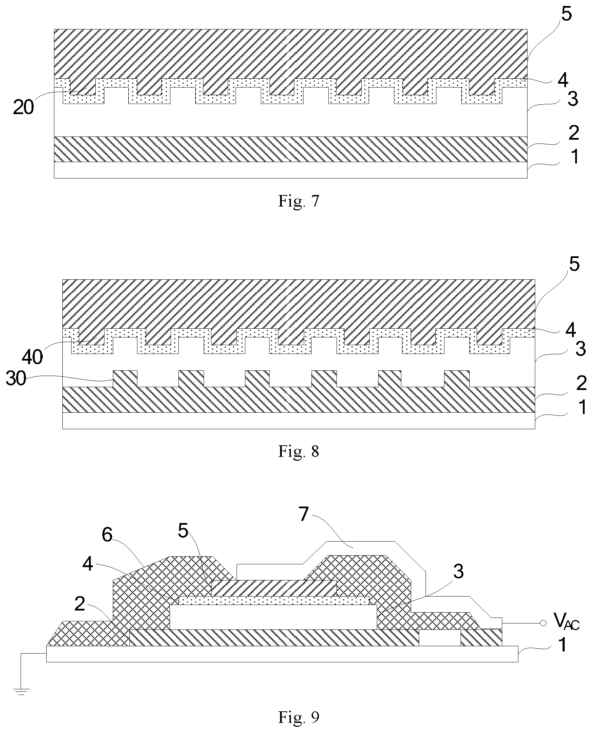

In an embodiment of the present disclosure, a third implementation form is shown in Fig. 7, the first electrode layer 2 is a full plate-shaped structure, or the first electrode layer 2 may include a patterned design, a side of the second electrode layer 5 close to the piezoelectric thin film layer 3 is provided with a plurality of second columnar structures 20, as such, while avoiding short circuits of the piezoelectric sensor by the insulating layer 4, by the plurality of second columnar structures 20, the contact area between the piezoelectric thin film layer 3 and the second electrode layer 5 is increased, structural stability between the piezoelectric thin film layer 3 and the second electrode layer 5 is ensured and the performance of the piezoelectric sensor is improved.

In some embodiments, the sizes of the plurality of the second columnar structures 20 are same, and the second columnar structures 20 may be unequally spaced from each other, or equally spaced, and the distribution of the second columnar structures 20 may be arranged according to the needs of the actual application without limitation. When the second columnar structures 20 are equally spaced, uniformity of the transmission rate at each location of the piezoelectric sensor is guaranteed, which guarantees the performance of the piezoelectric sensor in use.

In an embodiment of the present disclosure, a fourth implementation form is shown in Fig. 8, a side of the first electrode layer 2 close to the piezoelectric thin film layer 3 is provided with a plurality of third columnar structures 30, a side of the second electrode layer 5 close to the piezoelectric thin film layer 3 is provided with a plurality of fourth columnar structures 40, an orthographic projection of any one of the third columnar structures 30 on the base substrate 1 and an orthographic projection of any one of the fourth columnar structures 40 on the base substrate 1 do not overlap, the contact area between the piezoelectric thin film layer 3 and the first electrode layer 2 is increased by the plurality of third columnar structures 30, the contact area between the piezoelectric thin film layer 3 and the second electrode layer 5 is increased by the plurality of fourth columnar structures 40, thereby ensuring structural stability between the piezoelectric thin film layer 3 and the first electrode layer 2 as well as the second electrode layer 5, respectively, and improving the performance of the piezoelectric sensor. Furthermore, the orthographic projections of any one of the third columnar structures 30 and any one of the fourth columnar structures 40 on the substrate 1 do not overlap each other, for example, an orthographic projection of any one of the fourth columnar structures 40 on the base substrate 1 falls entirely within an area of an orthographic projection of a spacing region between two adjacent third columnar structures 30 on the base substrate 1. While taking into account the structural stability, the uniformity of the thickness of the piezoelectric thin film layer 3 is ensured, and the occurrence of easy breakdown at a thinner position due to the uneven thickness of the piezoelectric thin film layer 3 is avoided, thereby ensuring the service performance of the piezoelectric sensor.

In some embodiments, the sizes of the third columnar structures 30 are same, the sizes of the fourth columnar structures 40 are same, the third columnar structures 30 can be unequally spaced or equally spaced from each other, the fourth columnar structures 40 can be unequally spaced or equally spaced from each other, The distribution of the third columnar structures 30 and the fourth columnar structures 40 may be specifically set according to practical application requirements and is not limited herein. When the third columnar structures 30 are equally spaced and the fourth columnar structures 40 are equally spaced, uniformity of light transmission at each location of the piezoelectric sensor is guaranteed, and use performance of the piezoelectric sensor is guaranteed.

Of course, the first electrode layer 2 and the second electrode layer 5 may be provided in other ways according to actual needs in addition to the above four implementation forms in practical applications, which will not be described in detail here.

It should be noted that the thickness of the first electrode layer 2 is between 50 nm and 500 nm and the thickness of the second electrode layer 5 is between 50 nm and 500 nm, for example, the thickness of the first electrode layer 2 is 200 nm and the thickness of the second electrode layer 5 is 150 nm, and that the thicknesses of the first electrode layer 2 and the second electrode layer 5 can be arranged in an implementation form according to the needs of the actual application, which is not limited here. As used herein, "same" is not exactly same, and can be approximately same, or roughly same.

In an embodiment of the present disclosure, as shown in Fig. 9, which is a schematic structural diagram of the piezoelectric sensor, in addition to the film layers mentioned above, the piezoelectric sensor may further include a protective layer 6 disposed on the periphery of the first electrode layer 2, the piezoelectric thin film layer 3, the insulating layer 4, and the second electrode layer 5, and a routing layer 7 coupled by vias through the protective layer 6. In some embodiments, with the used of the inverse piezoelectric effect, the first electrode layer 2 is grounded and a high frequency AC voltage signal ($V_{AC}$) is applied to the second electrode layer 5, so that the high-frequency AC voltage signal is applied to the piezoelectric thin film layer 3 and the insulating layer 4, thereby generating high-frequency vibration. Laser can be used to measure vibration displacement, thereby ensuring the service performance of the piezoelectric sensor. The protective layer may be $SiO_2$, silicon nitride ($Si_3N_4$) or the like and is not limited herein. Of course, the piezoelectric sensor can be provided with other film layers according to the practical application in addition to the various film layers mentioned above and the arrangement in the related art can be referred to in detail.

It should be noted that, in an embodiment of the present disclosure, for the first electrode layer 2, the piezoelectric thin film layer 3, the insulating layer 4, the second electrode layer 5 that are stacked in sequence along the base substrate 1, the areas of the orthographic projections of them on the base substrate 1 tend to decrease, that is, an orthographic projection of the second electrode layer 5 on the base substrate 1 falls entirely within the area of an orthographic projection of the insulating layer 4 on the base substrate 1, the orthographic projection of the insulating layer 4 on the base substrate 1 falls entirely within the area of the orthographic projection of the piezoelectric thin film layer 3 on the base substrate 1 and the orthographic projection of the piezoelectric thin film layer 3 on the base substrate 1 falls entirely within the area of the orthographic projection of the first electrode layer 2 on the base substrate 1. In this way, the film layers have a segment difference with each other, on the one hand, the rapid leveling of each film layer in the wet process is ensured, on the other hand, the structural stability of the piezoelectric sensor is ensured, thereby improving the service performance of the piezoelectric sensor. Furthermore, the piezoelectric sensor can be applied in the fields of medical treatment, automotive electronics, motion tracking systems, and the like. It is especially suitable for the wearable equipment field, monitoring and treatment of in vitro or in vivo medical treatment, electronic skin of artificial intelligence and other fields. In particular, the piezoelectric sensor may be used in brake pads, keyboards, mobile terminals, gamepads, onboard vehicles, and the like that can generate vibration and mechanical characteristics.

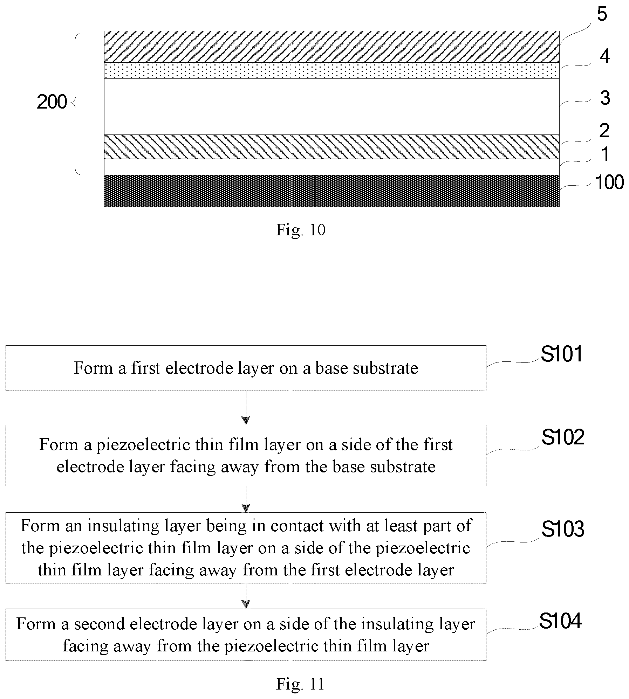

Based on the same disclosed concept, as shown in Fig. 10, an embodiment of the present disclosure also provides a haptic feedback device including a haptic feedback circuit 100 and the piezoelectric sensor 200 as described above; where: the haptic feedback circuit 100 is arranged on a side of the second electrode layer 5 facing away from the first electrode layer 2, or the haptic feedback circuit is arranged on a side of the first electrode layer 2 facing away from the second electrode layer 5, the haptic feedback circuit 100 being configured to generate a voltage pulse according to a received instruction to vibrate the structural body.

In some embodiments, the haptic feedback circuit 100 is arranged on a side of the first electrode layer 2 facing away from the second electrode layer 5 as illustrated in Fig. 10. For example, the haptic feedback device can be combined with a touch screen, and the touch position of the human body can be determined through the touch screen, thereby generating the corresponding vibration waveform, amplitude and frequency, and realizing human-computer interaction. For another example, it is also possible to multiplex the haptic feedback device as a piezoelectric body, and the touch position of the human body can be determined by the piezoelectric sensor, thereby generating the corresponding vibration waveform, amplitude and frequency, and realizing human-computer interaction. Of course, the tactile feedback device can also be applied in the fields of medical treatment, automotive electronics, motion tracking systems and the like according to actual needs, and will not be described in detail herein.

Furthermore, the principle of solving the problem with the haptic feedback device is similar to that of the aforementioned piezoelectric sensor, and therefore, the relevant structure of the piezoelectric sensor 200 in the haptic feedback device can be referred to the implementation of the aforementioned piezoelectric sensor 200, and the repetition is not repeated.

Based on the same disclosed concept, as illustrated in Fig. 11, an embodiment of the present disclosure also provides a fabrication method for a piezoelectric sensor, including:

S101: a first electrode layer is formed on a base substrate;

S102: a piezoelectric thin film layer is formed on a side of the first electrode layer facing away from the base substrate;

S103: an insulating layer in contact with at least part of the piezoelectric thin film layer is formed on a side of the piezoelectric thin film layer facing away from the first electrode layer;

S104: a second electrode layer is formed on a side of the insulating layer facing away from the piezoelectric thin film layer.

In some embodiments, the particular structure of the piezoelectric sensor in the fabrication method is the same as described in the previous section and is not described in detail herein. A specific implementation procedure for steps S101 to S103 is as follows: first, a first electrode layer 2 is formed on the base substrate 1, e.g., ITO is sputtered on the base substrate 1 and then the ITO is patterned by photolithography and etching to form the first electrode layer 2 in a desired pattern; then a piezoelectric thin film layer 3 is formed on the side of the first electrode layer 2 facing away from the base substrate 1, for example, the piezoelectric thin film layer 3 is deposited on the side of the first electrode layer 2 facing away from the base substrate 1, and then the piezoelectric thin film layer 3 is patterned by photolithography and etching to form the piezoelectric thin film layer 3 in a desired pattern; then an insulating layer 4 in contact with at least part of the piezoelectric thin film layer 3 is coated on a side of the piezoelectric thin film layer 3 facing away from the first electrode layer 2; the second electrode layer 5 is then formed on the side of the insulating layer 4 facing away from the piezoelectric thin film layer 3, for example, ITO is sputtered on the side of the insulating layer 4 facing away from the piezoelectric thin film layer 3, and the ITO is then patterned by photolithography and etching to form the second electrode layer 5 in the desired pattern.

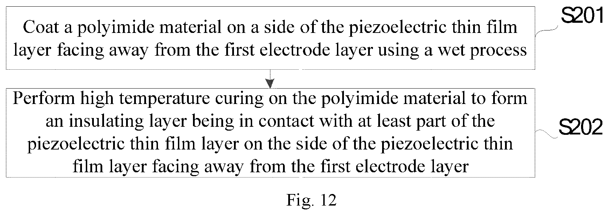

In an embodiment of the present disclosure, as illustrated in Fig. 12, step S103: an insulating layer in contact with at least part of the piezoelectric thin film layer is formed on a side of the piezoelectric thin film layer facing away from the first electrode layer, including:

S201: a polyimide material is coated on a side of the piezoelectric thin film layer facing away from the first electrode layer using a wet process;
S202: high temperature curing is performed on the polyimide material to form an insulating layer being in contact with at least part of the piezoelectric thin film layer on the side of the piezoelectric thin film layer facing away from the first electrode layer.

In some embodiments, the implementation procedure for steps S201 to S202 is as follows: first, a wet process is employed, a side of the piezoelectric thin film layer 3 facing away from the first electrode layer 2 is coated with a polyimide material, in the case of cracks in the piezoelectric thin film layer 3, the polyimide material will flow through gravitational leveling into the cracks due to strong capillary forces and pores at the cracks, thereby ensuring insulating properties between the piezoelectric thin film layer 3 and the second electrode layer 5; then, the polyimide material is subjected to high temperature curing, an insulating layer 4 making contact with at least part of the piezoelectric thin film layer 3 is formed on the side of the piezoelectric thin film layer 3 facing away from the first electrode layer 2, for example, the polyimide material is cured at 200°C, thus ensuring that the insulating layer 4 has stable insulating properties and further ensuring the performance of the piezoelectric sensor.

In some embodiments, the principle of solving the problem with the fabrication method for the piezoelectric sensor described above is similar to that of the piezoelectric sensor described above, and therefore, the fabrication method for the piezoelectric sensor can refer to the implementation of the piezoelectric sensor section described above, and the repetition thereof will not be repeated.

An embodiment of the present disclosure provides a piezoelectric sensor and a fabrication method, wherein the piezoelectric sensor includes the base substrate 1, and the first electrode layer 2, the piezoelectric thin film layer 3, the insulating layer 4 and the second electrode layer 5 which are arranged in sequence away from the base substrate 1, the insulating layer 4 is in contact with at least part of the piezoelectric thin film layer 3, even in the presence of cracks in the piezoelectric thin film layer 3, the cracks are filled by the insulating layer 4 effectively, so that the risk of short circuits between the second electrode layer 5 and the first electrode layer 2 due to contact, i.e. the risk of short circuits of the piezoelectric sensor, is avoided by the insulating layer 4 after deposition of the second electrode layer 5, thereby increasing the product yield.

Though the preferred embodiments of the disclosure are already described, those skilled in the art can make extra changes and modifications to these embodiments once they know a basic inventive concept. Therefore, the appended claims are intended to be constructed to include the preferred embodiments and changes and modifications may fall within the scope of the invention, as defined by the claims.

## Claims

1. A piezoelectric sensor, comprising:

   a base substrate (1),
   a first electrode layer (2), arranged on the base substrate (1);
   a piezoelectric thin film layer (3), arranged on a side of the first electrode layer (2) facing away from the base substrate (1);
   an insulating layer (4), arranged on a side of the piezoelectric thin film layer (3) facing away from the base substrate (1); and
   a second electrode layer (5), arranged on a side of the insulating layer (4) facing away from the base substrate (1);
   wherein the insulating layer (4) is in contact with at least part of the piezoelectric thin film layer (3);
   wherein a capacitance of the piezoelectric thin film layer (3) and a capacitance of the insulating layer (4) satisfy a following relationship:

   $$C_{PI} \geq 100 C_{PZT};$$

   wherein $C_{PI}$ represents the capacitance of the insulating layer (4) and $C_{PZT}$ represents the capacitance of the piezoelectric thin film layer (3);

**characterized in that**

a side of the first electrode layer (2) facing the piezoelectric thin film layer (3) is provided with a plurality of first columnar structures (10); or a side of the second electrode layer (5) facing the piezoelectric thin film layer (3) is provided with a plurality of second columnar structures (20).

2. The piezoelectric sensor according to claim 1, wherein the piezoelectric thin film layer (3) comprises at least one hollow structure (f), and each of the at least one hollow structure (f) is filled with the insulating layer (4).

3. The piezoelectric sensor according to any one of claims 1 to 2, wherein an orthographic projection of the piezoelectric thin film layer (3) on the base substrate (1) covers an orthographic projection of the insulating layer (4) on the base substrate (1).

4. The piezoelectric sensor according to any one of claims 1 to 2, wherein an orthographic projection of the insulating layer (4) on the base substrate (1) and an orthographic projection of the piezoelectric thin film layer (3) on the base substrate (1) overlap each other.

5. The piezoelectric sensor according to any one of claims 1 to 4, wherein a material of the insulating layer (4) comprises at least one of polyimide, silica, or alumina;

a material of the piezoelectric thin film layer (3) comprises at least one of aluminum nitride, zinc oxide, lead zirconate titanate, barium titanate, lead titanate, potassium niobate, lithium niobate, lithium tantalate, or lanthanum gallium silicate.

6. The piezoelectric sensor according to any one of claims 1 to 5, wherein a thickness of the insulating layer (4) and a thickness of the piezoelectric thin film layer (3) satisfy a following relationship:

$$d_{PI} \leq 0.1 * d_{PZT};$$

wherein $d_{PI}$ represents the thickness of the insulating layer (4) and $d_{PZT}$ represents the thickness of the piezoelectric thin film layer (3).

7. The piezoelectric sensor according to any one of claims 1 to 6, wherein a thickness of the insulating layer (4) is greater than or equal to 50 nm; and the thickness of the insulating layer (4) is less than or equal to 200 nm;

a thickness of the piezoelectric thin film layer (3) is greater than 0; and the thickness of the piezoelectric thin film layer (3) is less than or equal to 2 μm.

8. The piezoelectric sensor according to any one of claims 1 to 7, wherein a resistance of the piezoelectric thin film layer (3) and a resistance of the insulating layer (4) satisfy a following relationship:

$$R_{PI} \geq 1000 R_{PZT};$$

wherein $R_{PI}$ represents the resistance of the piezoelectric thin film layer (3) and $R_{PZT}$ represents the resistance of the insulating layer (4).

9. The piezoelectric sensor according to any one of claims 1 to 8, wherein a side of the piezoelectric thin film layer (3) facing away from the base substrate (1) is provided with a lyophilic material layer.

10. The piezoelectric sensor according to any one of claims 1 to 9, wherein a side of the first electrode layer (2) facing the piezoelectric thin film layer (3) is provided with a plurality of third columnar structures (30);

a side of the second electrode layer (5) facing the piezoelectric thin film layer (3) is provided with a plurality of fourth columnar structures (40); and an orthographic projection of each of the third columnar structures (30) on the base substrate (1) does not overlap with an orthographic projection of each of the fourth columnar structures (40) on the base substrate (1).

11. A haptic feedback device, comprising a haptic feedback circuit (100) and the piezoelectric sensor (200) according to any one of claims 1 to 10;

wherein: the haptic feedback circuit (100) is arranged on a side of the second electrode layer (5) facing away from the first electrode layer (2); or

the haptic feedback circuit (100) is arranged on a side of the first electrode layer (2) facing away from the second electrode layer (5);

wherein the haptic feedback circuit (100) is configured to generate a voltage pulse in accordance with a received instruction to cause a structural body to vibrate.

**Patentansprüche**

1. Piezoelektrischer Sensor, aufweisend:

ein Basissubstrat (1),

eine erste Elektrodenschicht (2), die auf dem Basissubstrat (1) angeordnet ist;

eine piezoelektrische Dünnfilmschicht (3), die auf einer Seite der ersten Elektrodenschicht (2) angeordnet ist, die von dem Basissubstrat (1) abgewandt ist;

eine Isolierschicht (4), die auf einer Seite der piezoelektrischen Dünnfilmschicht (3) angeordnet ist, die von dem Basissubstrat (1) abgewandt ist; und

eine zweite Elektrodenschicht (5), die auf einer Seite der Isolierschicht (4) angeordnet ist, die von dem Basissubstrat (1) abgewandt ist;

wobei die Isolierschicht (4) mit mindestens einem Teil der piezoelektrischen Dünnfilmschicht (3) in Kontakt steht;

wobei eine Kapazität der piezoelektrischen Dünnfilmschicht (3) und eine Kapazität der Isolierschicht (4) die folgende Beziehung erfüllen:

$$C_{PI} \geq 100 C_{PZT};$$

wobei $C_{PI}$ die Kapazität der Isolierschicht (4) darstellt und $C_{PZT}$ die Kapazität der piezoelektrischen Dünnfilmschicht (3) darstellt; **dadurch gekennzeichnet, dass**

eine Seite der ersten Elektrodenschicht (2), die der piezoelektrischen Dünnfilmschicht (3) zugewandt ist, mit mehreren ersten säulenförmigen Strukturen (10) versehen ist; oder

eine Seite der zweiten Elektrodenschicht (5), die der piezoelektrischen Dünnfilmschicht (3) zugewandt ist, mit mehreren zweiten säulenförmigen Strukturen (20) versehen ist.

2. Piezoelektrischer Sensor nach Anspruch 1, wobei die piezoelektrische Dünnfilmschicht (3) mindestens eine hohle Struktur (f) aufweist und jede der mindestens einen hohlen Struktur (f) mit der Isolierschicht (4) gefüllt ist.

3. Piezoelektrischer Sensor nach einem der Ansprüche 1 bis 2, wobei eine orthographische Projektion der piezoelektrischen Dünnfilmschicht (3) auf dem Basissubstrat (1) eine orthographische Projektion der Isolierschicht (4) auf dem Basissubstrat (1) bedeckt.

4. Piezoelektrischer Sensor nach einem der Ansprüche 1 bis 2, wobei sich eine orthographische Projektion der Isolierschicht (4) auf dem Basissubstrat (1) und eine orthographische Projektion der piezoelektrischen Dünnfilmschicht (3) auf dem Basissubstrat (1) überlappen.

5. Piezoelektrischer Sensor nach einem der Ansprüche 1 bis 4, wobei ein Material der Isolierschicht (4) mindestens eines von Polyimid, Siliziumdioxid oder Aluminiumoxid aufweist;

ein Material der piezoelektrischen Dünnfilmschicht (3) mindestens eines von Aluminiumnitrid, Zinkoxid, Bleizirkonattitanat, Bariumtitanat, Bleititanat, Kaliumniobat, Lithiumniobat, Lithiumtantalat oder Lanthanoxid-Gallium-Silikat umfasst.

6. Piezoelektrischer Sensor nach einem der Ansprüche 1 bis 5, wobei die Dicke der Isolierschicht (4) und die Dicke der piezoelektrischen Dünnfilmschicht (3) die folgende Beziehung erfüllen:

$$d_{PI} \leq 0,1 * d_{PZT};$$

wobei $d_{PI}$ die Dicke der Isolierschicht (4) darstellt und $d_{PZT}$ die Dicke der piezoelektrischen Dünnfilmschicht (3) darstellt.

7. Piezoelektrischer Sensor nach einem der Ansprüche 1 bis 6, wobei die Dicke der Isolierschicht (4) größer oder gleich 50 nm ist und die Dicke der Isolierschicht (4) kleiner oder gleich 200 nm ist;
die Dicke der piezoelektrischen Dünnfilmschicht (3) größer als 0 ist; und die Dicke der piezoelektrischen Dünnfilmschicht (3) kleiner oder gleich 2 $\mu$m ist.

8. Piezoelektrischer Sensor nach einem der Ansprüche 1 bis 7, wobei ein Widerstand der piezoelektrischen Dünnfilmschicht (3) und ein Widerstand der Isolierschicht (4) die folgende Beziehung erfüllen:

$$R_{PI} \geq 1000 R_{PZT};$$

wobei $R_{PI}$ den Widerstand der piezoelektrischen Dünnfilmschicht (3) darstellt und $R_{PZT}$ den Widerstand der Isolierschicht (4) darstellt.

9. Piezoelektrischer Sensor nach einem der Ansprüche 1 bis 8, wobei eine Seite der piezoelektrischen Dünnfilmschicht (3), die von dem Basissubstrat (1) abgewandt ist, mit einer Schicht aus einem lyophilen Material versehen ist.

10. Piezoelektrischer Sensor nach einem der Ansprüche 1 bis 9, wobei eine Seite der ersten Elektrodenschicht (2), die der piezoelektrischen Dünnfilmschicht (3) zugewandt ist, mit mehreren dritten säulenförmigen Strukturen (30) versehen ist;

eine Seite der zweiten Elektrodenschicht (5), die der piezoelektrischen Dünnfilmschicht (3) zugewandt ist, mit mehreren vierten säulenförmigen Strukturen (40) versehen ist; und
eine orthographische Projektion jeder der dritten säulenförmigen Strukturen (30) auf dem Basissubstrat (1) sich mit einer orthographischen Projektion jeder der vierten säulenförmigen Strukturen (40) auf dem Basissubstrat (1) nicht überlappt.

11. Haptische Rückmeldungsvorrichtung, eine haptische Rückmeldungsschaltung (100) und den piezoelektrischen Sensor (200) nach einem der Ansprüche 1 bis 10 aufweisend;

   wobei: die haptische Rückmeldungsschaltung (100) auf einer Seite der zweiten Elektrodenschicht (5) angeordnet ist, die von der ersten Elektrodenschicht (2) abgewandt ist; oder die haptische Rückmeldungsschaltung (100) auf einer Seite der ersten Elektrodenschicht (2) angeordnet ist, die von der zweiten Elektrodenschicht (5) abgewandt ist;
   wobei die haptische Rückmeldungsschaltung (100) konfiguriert ist, um gemäß einer empfangenen Anweisung einen Spannungsimpuls zu erzeugen, um einen Strukturkörper zum Schwingen zu bringen.

**Revendications**

1. Capteur piézoélectrique, comprenant :

   un substrat de base (1),
   une première couche d'électrode (2), disposée sur le substrat de base (1) ;
   une couche de film mince piézoélectrique (3), disposée sur un côté de la première couche d'électrode (2) opposé au substrat de base (1) ;
   une couche isolante (4), disposée sur un côté de la couche de film mince piézoélectrique (3) opposé au substrat de base (1) ; et
   une deuxième couche d'électrode (5), disposée sur un côté de la couche isolante (4) opposé au substrat de base (1) ;
   dans lequel la couche isolante (4) est en contact avec au moins une partie de la couche mince piézoélectrique (3) ;
   dans lequel une capacité de la couche mince piézoélectrique (3) et une capacité de la couche isolante (4) satisfait à la relation suivante :

   $$C_{PI} \geq 100 C_{PZT} \; ;$$

   où $C_{PI}$ représente la capacité de la couche isolante (4) et $C_{PZT}$ représente la capacité de la couche mince piézoélectrique (3) ;
   **caractérisé en ce que** un côté de la première couche d'électrode (2) faisant face à la couche de film mince piézoélectrique (3) est pourvu d'une pluralité de premières structures colonnaires (10) ; ou bien
   un côté de la deuxième couche d'électrode (5) faisant face à la couche de film mince piézoélectrique (3) est pourvu d'une pluralité de deuxièmes structures colonnaires (20).

2. Capteur piézoélectrique selon la revendication 1, dans lequel la couche de film mince piézoélectrique (3) comprend au moins une structure creuse (f), et chacune des au moins une structure creuse (f) est remplie de la couche isolante (4).

3. Capteur piézoélectrique selon l'une quelconque des revendications 1 à 2, dans lequel une projection orthographique de la couche mince piézoélectrique (3) sur le substrat de base (1) recouvre une projection orthographique de la couche isolante (4) sur le substrat de base (1).

4. Capteur piézoélectrique selon l'une quelconque des revendications 1 à 2, dans lequel une projection orthographique de la couche isolante (4) sur le substrat de base (1) et une projection orthographique de la couche mince piézoélectrique (3) sur le substrat de base (1) se chevauchent.

5. Capteur piézoélectrique selon l'une quelconque des revendications 1 à 4, dans lequel un matériau de la couche isolante (4) comprend au moins l'un parmi le polyimide, la silice ou l'alumine ;
   un matériau de la couche mince piézoélectrique (3) comprend au moins l'un parmi le nitrure d'aluminium, l'oxyde de zinc, le zirconate de plomb et de titane, le titanate de baryum, le titanate de plomb, le niobate de potassium, le niobate de lithium, le tantalate de lithium ou le silicate de lanthane et de gallium.

6. Capteur piézoélectrique selon l'une quelconque des revendications 1 à 5, dans lequel l'épaisseur de la couche isolante (4) et l'épaisseur de la couche mince piézoélectrique (3) satisfont à une relation :

   $$d_{PI} \leq 0.1^* d_{PZT} \; ;$$

   où $d_{PI}$ représente l'épaisseur de la couche isolante (4) et $d_{PZT}$ représente l'épaisseur de la couche mince piézoélectrique (3).

7. Capteur piézoélectrique selon l'une quelconque des revendications 1 à 6, dans lequel une épaisseur de la couche isolante (4) est supérieure ou égale à 50 nm ; et l'épaisseur de la couche isolante (4) est inférieure ou égale à 200 nm ;
   une épaisseur de la couche mince piézoélectrique (3) est supérieure à 0 ; et l'épaisseur de la couche mince piézoélectrique (3) est inférieure ou égale à

2μm.

8. Capteur piézoélectrique selon l'une quelconque des revendications 1 à 7, dans lequel la résistance de la couche mince piézoélectrique (3) et la résistance de la couche isolante (4) satisfont à la relation suivante :

$$R_{PI} \geq 1000 RP_{ZT} \; ;$$

où $R_{PI}$ représente la résistance de la couche mince piézoélectrique (3) et $R_{PZT}$ représente la résistance de la couche isolante (4).

9. Capteur piézoélectrique selon l'une quelconque des revendications 1 à 8, dans lequel un côté de la couche mince piézoélectrique (3) opposé au substrat de base (1) est pourvu d'une couche de matériau lyophile.

10. Capteur piézoélectrique selon l'une quelconque des revendications 1 à 9, dans lequel un côté de la première couche d'électrode (2) faisant face à la couche mince piézoélectrique (3) est pourvu d'une pluralité de troisièmes structures colonnaires (30) ;

un côté de la deuxième couche d'électrode (5) faisant face à la couche de film mince piézoélectrique (3) est pourvue d'une pluralité de quatrièmes structures colonnaires (40) ; et
une projection orthographique de chacune des troisièmes structures colonnaires (30) sur le substrat de base (1) ne chevauche pas une projection orthographique de chacune des quatrièmes structures colonnaires (40) sur le substrat de base (1).

11. Dispositif de retour haptique, comprenant un circuit de retour haptique (100) et le capteur piézoélectrique (200) selon l'une quelconque des revendications 1 à 10 ;

dans lequel : le circuit de retour haptique (100) est disposé sur un côté de la deuxième couche d'électrodes (5) opposé à la première couche d'électrodes (2) ; ou bien
le circuit de retour haptique (100) est disposé sur un côté de la première couche d'électrodes (2) opposé à la deuxième couche d'électrodes (5) ;
dans lequel le circuit de retour haptique (100) est configuré pour générer une impulsion de tension conformément à une instruction reçue afin de faire vibrer un corps structurel.

Fig. 1

Fig. 2

Fig. 3

b(c)(d)

4

f

5

3

2

1

Fig. 4

d

b(c)

4

f

5

3

2

1

Fig. 5

5

4

3

10

2

1

Fig. 6

5

4

3

2

1

20

Fig. 7

5

4

3

2

1

40

30

Fig. 8

7

6

5

4

3

2

1

$V_{AC}$

Fig. 9

Fig. 10

| Form a first electrode layer on a base substrate | S101 |

↓

| Form a piezoelectric thin film layer on a side of the first electrode layer facing away from the base substrate | S102 |

↓

| Form an insulating layer being in contact with at least part of the piezoelectric thin film layer on a side of the piezoelectric thin film layer facing away from the first electrode layer | S103 |

↓

| Form a second electrode layer on a side of the insulating layer facing away from the piezoelectric thin film layer | S104 |

Fig. 11

Coat a polyimide material on a side of the piezoelectric thin film layer facing away from the first electrode layer using a wet process

S201

Perform high temperature curing on the polyimide material to form an insulating layer being in contact with at least part of the piezoelectric thin film layer on the side of the piezoelectric thin film layer facing away from the first electrode layer

S202

Fig. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016204333 A1